# EUROPÄISCHE PATENTSCHRIFT

(11) **EP 0 907 254 B1**
(45) Veröffentlichungstag und Bekanntmachung des Hinweises auf die Patenterteilung: **02.02.2005**
(21) Anmeldenummer: 98118628.1
(22) Anmeldetag: 01.10.1998
(51) Int. Cl.: H03L 7/185

(54) **Regelkreis zur Stabilisierung eines Mikrowellenoszillators**
Control loop for stabilising a microwave oscillator
Boucle de régulation pour stabiliser un oscillateur micro-onde

(30) Priorität: 04.10.1997 DE 19743879
(43) Veröffentlichungstag der Anmeldung: 07.04.1999
(73) Patentinhaber: EADS Deutschland GmbH, 81663 München (DE)
(72) Erfinder: Nüchter, Peter, 89079 Ulm (DE)
(74) Vertreter: Meel, Thomas

(56) Entgegenhaltungen:
- DE-A- 4 111 920
- HILT A. ET AL: "Millimeter Wave Synthesizer Locked To An Optically Transmitted Reference Using Harmonic Mixing" MICROWAVE PHOTONICS, 1997. MWP '97. INTERNATIONAL TOPICAL MEETING ON, 3. - 5. September 1997, Seiten 91-94, XP010319031
- NUCHTER P ET AL: "A mm-wave frequency divider" MICROWAVE SYMPOSIUM DIGEST, 1992., IEEE MTT-S INTERNATIONAL ALBUQUERQUE, NM, USA 1-5 JUNE 1992, NEW YORK, NY, USA,IEEE, US, 1. Juni 1992 (1992-06-01), Seiten 695-697, XP010062938 ISBN: 0-7803-0611-2

## Beschreibung

Die Erfindung bezieht sich auf einen Regelkreis zur Stabilisierung eines Mikrowellenoszillators.

Allgemein bekannt sind Regelkreise dieser Art, die in Form einer Phase-Locked-Loop (PLL) realisiert sind. Dabei wird z.B. über einen Richtkoppler ein Teil des Ausgangssignals des in Frequenz und/oder Phase zu stabilisierenden Mikrowellenoszillators ausgekoppelt und dem einen Eingangstor eines Phasen-/Frequenzdetektors zugeführt. Dem anderen Eingangstor des Detektors wird ein phasen- und frequenzstabiles Referenzsignal zugeführt und mit dem ausgekoppelten Teil des Ausgangssignals des Mikrowellenoszillators verglichen. Am Ausgangstor des Phasen-/Frequenzdetektors erscheint dann bei Abweichung des Mikrowellenoszillatorausgangssignals vom Referenzsignal ein Regelsignal, das über ein Regelfilter dem Regeleingang des Mikrowellenoszillators zugeführt wird und dessen Phase bzw. Frequenz nachregelt.

Im Mikrowellenbereich, und hier insbesondere im Millimeterwellenbereich, sind solche PLL-Schaltungen aufgrund der hohen Frequenzen in der geschilderten Form nicht so ohne weiteres realisierbar. In der Regel werden für die PLL-Schaltungen Frequenzteiler benutzt, um das zu stabilisierende Oszillatorsignal zunächst in einen niederen Frequenzbereich zu überführen und in diesem Frequenzbereich den Phasen-/-Frequenzvergleich mit dem Referenzsignal durchzuführen.

Aus der DE 41 11 920 A1 ist eine solche Frequenzteilerschaltung bekannt. Dort wird ein Teil des Ausgangssignals der Frequenz f_{OSZ} des zu stabilisierenden Mikrowellenoszillators über einen Richtkoppler ausgekoppelt und einem Oberwellenmischer zugeführt, in dem das Oszillatorsignal f_{OSZ} mit der n-ten Oberwelle eines Pumposzillators der Frequenz f_{P} gemischt wird. Aus dem Spektrum der Mischsignale des Oberwellenmischers wird ein Frequenzband, z.B. das Zwischenfrequenzband mit der Frequenzlage fᵤ = f_{OSZ} - n·f_{P}, herausgefiltert und verstärkt und anschließend einem (n:1)-Frequenzteiler zugeführt. Am Ausgang des Frequenzteilers erscheint dementsprechend ein Signal mit der Frequenz f_{OSZ}/n - f_{P}, das einem Mischer zugeleitet wird und dort mit dem Ausgangssignal der Frequenz f_{P} des Pumposzillators derart gemischt wird, daß am Ausgang des Mischers dann ein Signal der Frequenz f_{OSZ}/n erscheint.

Mit dieser Schaltung wird mit anderen Worten die Frequenz f_{OSZ} des Oszillatorsignals mit Hilfe des Pumposzillators auf f_{OSZ}/n heruntergeteilt.

Aus der DE 41 11 920 A1 ist ferner ein weiterer Frequenzteiler bekannt, der sich von dem zuvor beschriebenen Fequenzteiler dadurch unterscheidet, daß anstelle des Oberwellenmischers ein normaler Mischer vorgesehen ist, der über einen Frequenzvervielfacher (Vervielfachung um den Faktor n) mit dem Pumposzillator verbunden ist. Der sonstige Aufbau und die Funktionsweise des Teilers stimmen im übrigen mit dem zuvor beschriebenen Frequenzteiler überein.

Eine weitere Frequenzteilerschaltung für den Mikrowellenbereich ist aus der DE 41 11 919 A1 bekannt. Dort wird in einem Rückkopplungskreis ein niederfrequentes Signal der Frequenz f_{S} verstärkt und in seiner Frequenz verdoppelt. Das Signal bei der doppelten Frequenz 2f_{S} wird anschließend nochmals verstärkt und mit einem hochfrequenten Signal der Frequenz f_{OSZ} eines Mikrowellenoszillators auf einen Oberwellenmischer gegeben. Im Oberwellenmischer wird die n-te harmonische Oberschwingung des Signals mit der verdoppelten Frequenz 2f_{S} derart gewählt, daß als Zwischenfrequenzsignal ein Signal der Frequenz f_{S} erzeugt wird.

Die Aufgabe der vorliegenden Erfindung besteht darin, einen Regelkreis zur Stabilisierung eines Mikrowellenoszillators anzugeben, der möglichst einfach im Aufbau ist und möglichst mit Standardbauteilen auskommt.

Die erfindungsgemäße Lösung dieser Aufgabe ist durch die Merkmale des Patentanspruchs 1 wiedergegeben. Die übrigen Ansprüche enthalten vorteilhafte Aus- und Weiterbildungen der Erfindung.

Ein wesentlicher Vorteil der Erfindung ist darin zu sehen, daß im Vergleich zur bekannten Lösung nach DE 41 11 920 A1 die erfindungsgemäße Lösung keinen Einseitenbandmischer benötigt, sondern lediglich einen Standardmischer.

Ein weiterer Vorteil des Verfahrens im Vergleich zur vorbekannten Lösung besteht darin, daß die Frequenz des Referenzsignals f_{Ref} höher als die Vergleichsfrequenz des Phasen-/Frequenzdetektors f_{Det} ist. Dadurch können einerseits Standard-PLL-Komponenten in einem entsprechend niedrigen Frequenzbereich eingesetzt werden, während andererseits für die Vervielfachung der maßgeblichen Phasenrauschbeiträge der PLL-Komponenten und des Referenzsignals das Verhältnis f_{OSZ}/f_{Ref} relevant ist. Dies ist hier günstiger als das Verhältnis f_{OSZ}/f_{Det}, das bei der vorbekannten Lösung zum Tragen kommt.

Ein dritter Vorteil der Erfindung besteht darin, daß mit der Erfindung Mikrowellen- und hier insbesondere Millimeterwellenoszillatoren sehr effektiv in ihrer Frequenz und Phase gegen Drifterscheinungen und Phasenrauschen (Temperaturdrift, mechanische Spannungen, Alterungserscheinungen) stabilisiert werden können, ohne daß eine eigenständige Stabilisierung des Pumposzillators erforderlich ist.

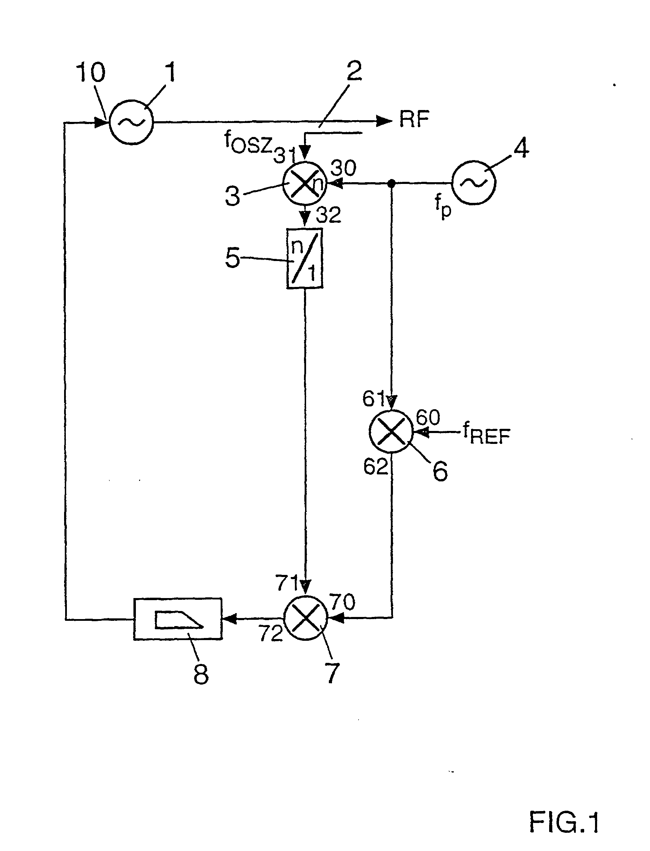

Im folgenden wird die Erfindung anhand der Figuren näher erläutert. Die FIG. 1 bis 3 zeigen drei unterschiedliche bevorzugte Ausführungsformen des erfindungsgemäßen Regelkreises.

Der Regelkreis in FIG. 1 weist einen in Frequenz und Phase zu stabilisierenden Mikrowellenoszillator 1 auf, dessen Ausgangssignal der Frequenz f_{OSZ} über einen Richtkoppler zu einem kleinen Teil ausgekoppelt wird und dem zweiten Eingangstor 31 eines Oberwellenmischers 3 zugeführt wird. Dem ersten Eingangtor 30 des Oberwellenmischers 3 ist das Ausgangssignal der Frequenz fp eines Pumposzillators 4 zugeführt. Im Mischer wird das Ausgangssignal des Oszillators der Frequenz f_{OSZ} mit der n-ten Oberschwingung des Ausgangssignals der Frequenz f_{P} des Pumposzillators gemischt und am Ausgangstor 32 des Oberwellenmischers 3 das Mischprodukt der Frequenz f_{OSZ} - nf_{P} (oder alternativ: nf_{P} - f_{OSZ}) ausgegeben. Das Mischprodukt, hier also beispielhaft das Zwischenfrequenzband bei f_{OSZ} - nf_{P}, wird in einem ausgangsseitig nachgeschalteten (n:1)-Frequenzteiler heruntergeteilt auf f_{OSZ}/n - f_{P}. Dieses im Frequenzbereich auf f_{OSZ}/n - f_{P} heruntertransformierte Signal ist mit dem zweiten Eingangstor 71 eines Phasen-/Frequenzdetektors 7 verbunden. Der Pumposzillator ist ausgangsseitig ferner mit dem ersten Eingangstor 61 eines ersten Mischers 6 verbunden, an dessen zweitem Eingangstor 60 ein Referenzsignal der Frequenz f_{Ref} anliegt. Das Mischprodukt (beispielhaft: f_{Ref} - f_{P}) am Ausgang 62 des ersten Mischers 6 wird dem ersten Eingangstor 70 des Phasen-/Frequenzdetektors 7 zugeleitet und mit dem am zweiten Eingangstor 71 anliegenden Eingangssignal f_{OSZ}/n - f_{P} gemischt, dergestalt, daß am Ausgangstor 72 des Phasen-/Frequenzdetektors ein Signal bei der Frequenz f_{OSZ}/n - f_{Ref} = 0 erscheint.

Dieses Signal stellt das Regelsignal für den Mikrowellenoszillator 1 dar und wird über ein Regelfilter 8 dem Regeleingang 10 des Oszillators 1 zugeführt. Wird vom Phasen-/-Frequenzdetektor 7 eine Abweichung in Phase und/oder Frequenz zwischen f_{OSZ}/n und f_{Ref} festgestellt, wird ein entsprechendes Regelsignal am Ausgang 72 des Detektors 7 ausgegeben, mit dem der Oszillator 1 in Frequenz und/oder Phase auf den Sollwert nachgeregelt wird.

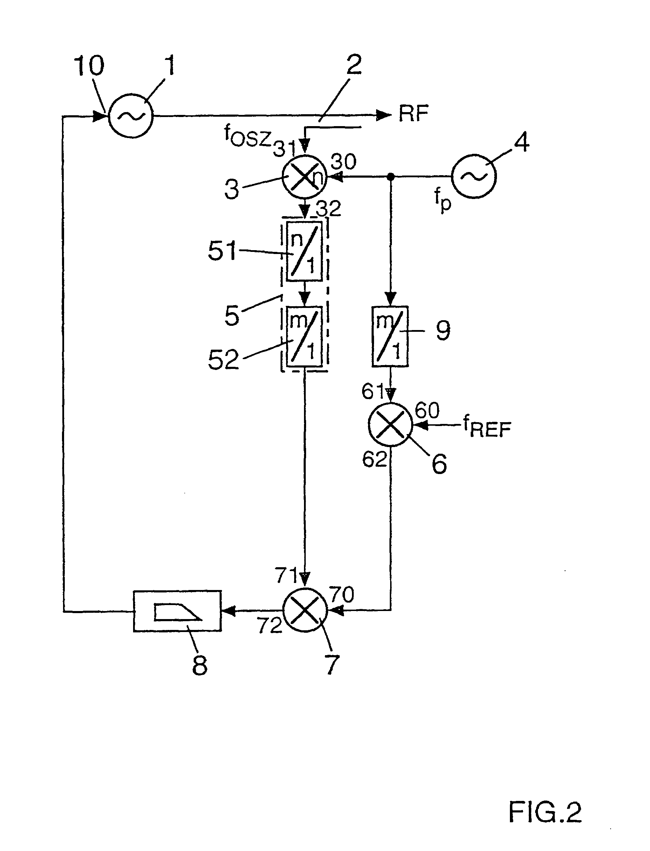

Der Regelkreis in FIG. 2 unterscheidet sich von dem Regelkreis der FIG. 1 lediglich dadurch, daß der erste Frequenzteiler 5 in zwei in Reihe geschaltete Teil-Frequenzteiler 51 und 52 aufgeteilt ist und daß der Pumposzillator 1 über einen zweiten Frequenzteiler 9 mit dem ersten Eingangstor 61 des Mischers 6 verbunden ist. Der Teilungsfaktor T11 = n des ersten Teil-Frequenzteilers 51 stimmt dabei mit dem Multiplikationsfaktor M = n des Oberwellenmischers 3 überein, während der Teilungsfaktor T12 des zweiten Teil-Frequenzteilers 52 mit dem Teilungsfaktor T2=m des zweiten Frequenzteilers 9 übereinstimmt.

Diese zusätzlichen Frequenzteiler haben zur Folge, daß einerseits das Referenzsignal mit dem Pumposzillatorsignal der Frequenz f_{P}/m gemischt wird und andererseits das Oberwellenmischer-Ausgangssignal durch n und m geteilt wird, also bei f_{OSZ}/(n·m) - f_{P}/m liegt.

Bei der anschließenden Mischung im Phasen-/Frequenzdetektor 7 fällt der in beiden Signalfrequenzen enthaltene gemeinsame Bestandteil f_{P}/m wieder heraus, so daß zur Ableitung des Regelsignals hier f_{OSZ}/(n·m) mit f_{Ref} verglichen wird.

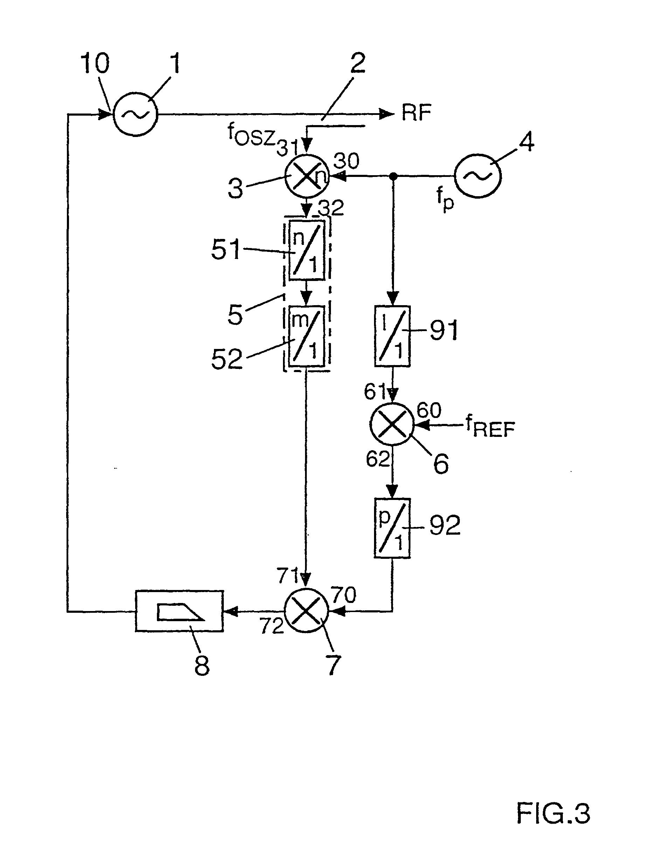

Der Regelkreis in FIG. 3 unterscheidet sich von dem Regelkreis in FIG. 2 lediglich dadurch, daß anstelle des einen zweiten Frequenzteilers mit dem Teilungsverhältnis m:1 nunmehr ein zweiter und ein dritter Frequenzteiler 91, 92 vorgesehen sind mit den Teilungsverhältnissen l:1 und p:1, wobei die Bedingung gilt l + p = m. Zur Ableitung des Regelsignals wird hier die Größe f_{OSZ}/(n·m) mit der Größe f_{Ref}/p verglichen. Die Funktionsweise und der Aufbau stimmen im übrigen überein mit dem Regelkreis der FIG. 2.

Es versteht sich, daß die Erfindung nicht auf die dargestellten Ausführungsbeispiele beschränkt ist, sondern vielmehr auf weitere übertragbar ist. So können die Frequenzteiler in den einzelnen Zweigen der Schaltung durch entsprechende andere Reihenschaltungen von Teil-Frequenzteilern ersetzt werden.

Ferner können Gruppenlaufzeitunterschiede zwischen den beiden Signalpfaden der Teiler-/Mischeranordnung mit Hilfe zwischengeschalteter Verzögerungsleitungen bzw. Verzögerungsglieder ausgeglichen werden.

Auch ist es möglich, anstelle des in den Ausführungsbeispielen ausgewählten unteren Zwischenfrequenzbandes f_{OSZ} - nf_{P} das Zwischenfrequenzband nf_{P} - f_{OSZ} (bei entsprechender Anpassung/Auswahl der anderen relevanten Mischprodukte des Regelkreises) zu verwenden. Auch muß das Ausgangssignal des Oberwellenmischers nicht unbedingt im Basisband liegen. Prinzipiell ist jede Zwischenfrequenzlage möglich.

Schließlich kann je nach Anwendung anstelle eines Phasen/-Frequenzdetektors auch ein reiner Phasendetektor oder ein reiner Frequenzdetektor verwendet werden.

## Patentansprüche

1. Regelkreis zur Stabilisierung eines Mikrowellenoszillators, **gekennzeichnet durch** folgende Merkmale:
- ein Pumposzillator (4) der Frequenz f_{P} ist ausgangsseitig mit dem ersten Eingangstor (61) eines ersten Mischers (6) und dem ersten Eingangstor (30) eines Oberwellenmischers (3) verbunden,
- dem ersten Mischer (6) ist über sein zweites Eingangstor (60) ein Referenzsignal der Frequenz f_{Ref} zugeführt,
- dem Oberwellenmischer (3) ist über sein zweites Eingangstor (31) ein ausgekoppelter Teil des Ausgangssignals der Frequenz f_{OSZ} des Mikrowellenoszillators (1) zugeführt,
- ein Phasen-/Frequenzdetektor (7) oder ein Phasendetektor oder ein Frequenzdetektor ist mit seinem ersten Eingangstor (70) mit dem Ausgangstor (62) des ersten Mischers (6) und mit seinem zweiten Eingangstor (71) über einen ersten Frequenzteiler (5) mit dem Ausgangstor (32) des Oberwellenmischers (3) und mit seinem Augangstor (72) mit dem Regeleingang (10) des Mikrowellenoszillators (1) verbunden,
- das Verhältnis T1/M des Teilungsfaktors T1 des ersten Frequenzteilers (5) zu dem Multiplikationsfaktor M des Oberwellenmischers (3) ist ganzzahlig.

2. Regelkreis nach Anspruch 1, **dadurch gekennzeichnet,**
- **daß** der Pumposzillator (4) über einen zweiten Frequenzteiler (9) mit dem ersten Mischer (6) verbunden ist,
- **daß** das Verhältnis T1/T2 der Teilungsfaktoren T1, T2 des ersten und zweiten Frequenzteilers (5, 9) gleich ist dem Multiplikationsfaktor M des Oberwellenmischers (3).

3. Regelkreis nach Anspruch 2, **dadurch gekennzeichnet, daß** der erste Frequenzteiler (5) aus zwei in Reihe geschalteten Teil-Frequenzteilern (51, 52) besteht und daß das Produkt T11·T12 des Teilungsfaktors T11 des ersten Teil-Frequenzteilers (51) mit dem Teilungsfaktor T12 des zweiten Teil-Frequenzteilers (52) gleich ist dem Produkt M·T2 des Multiplikationsfaktors M des Oberwellenmischers (3) und des Teilungsfaktors T2 des zweiten Frequenzteilers (6).

4. Regelkreis nach einem der vorhergehenden Ansprüche, **dadurch gekennzeichnet,**
- **daß** der erste Mischer (6) über einen dritten Frequenzteiler (92) mit dem ersten Eingangstor (70) des Phasen-/-Frequenzdetektors (7) oder Phasendetektors oder Frequenzdetektors verbunden ist,
- **daß** das Verhältnis T1/T3 bzw. T1/T2·T3 der Teilungsfaktoren T1, T3 des ersten und dritten Frequenzteilers (5, 92) bzw. des ersten und des zweiten und dritten Frequenzteilers (5; 91, 92) gleich ist dem Multiplikationsfaktor M des Oberwellenmischers (3).

5. Regelkreis nach einem der vorhergehenden Ansprüche, **dadurch gekennzeichnet, daß** dem Phasen-/Frequenzdetektor (7) oder Phasendetektor oder Frequenzdetektor ausgangsseitig ein Regelfilter (8) nachgeschaltet ist.

6. Regelkreis nach einem der vorhergehenden Ansprüche, **dadurch gekennzeichnet, daß** zwischen Oberwellenmischer (3) und Phasen-/Frequenzdetektor (7) oder Phasendetektor oder Frequenzdetektor und/oder zwischen Pumposzillator (4) und Phasen-/Frequenzdetektor (7) oder Phasendetektor oder Frequenzdetektor ein Verzögerungsglied oder eine Verzögerungsleitung geschaltet ist.

7. Regelkreis nach einem der vorhergehenden Ansprüche, **dadurch gekennzeichnet, daß** der Oberwellenmischer (3) ersetzt ist durch eine Reihenschaltung aus zweitem Mischer und zwischen zweitem Mischer und Pumposzillator geschaltetem Frequenzvervielfacher.

## Claims

1. Control loop for stabilization of a microwave oscillator, **characterized by** the following features:
- a pump oscillator (4) at a frequency fₚ is connected on the output side to the first input port (61) of a first mixer (6) and to the first input port (30) of a harmonic mixer (3),
- the first mixer (6) is supplied with a reference signal at the frequency f_{Ref} via its second input port (60),
- the harmonic mixer (3) is supplied with an output portion of the output signal at the frequency fosc from the microwave oscillator (1) via its second input port (31),
- a phase/frequency detector (7), a phase detector, or a frequency detector is connected by its first input port (70) to the output port (62) of the first mixer (6), and by its second input port (71) via a first frequency divider (5) to the output port (32) of the harmonic mixer (3), and by its output port (72) to the control input (10) of the microwave oscillator (1),
- the ratio T1/M of the division factor T1 of the first frequency divider (5) to the multiplication factor M of the harmonic mixer (3) is an integer.

2. Control loop according to Claim 1, **characterized**
- **in that** the pump oscillator (4) is connected to the first mixer (6) via a second frequency divider (9),
- **in that** the ratio T1/T2 of the division factors T1, T2 of the first and of the second frequency divider (5, 9) is equal to the multiplication factor M of the harmonic mixer (3).

3. Control loop according to Claim 2, **characterized in that** the first frequency divider (5) comprises two series-connected frequency divider elements (51, 52), and **in that** the product T11·T22 of the division factor T11 of the first frequency divider element (51) and the division factor T12 of the second frequency divider element (52) is equal to the product M·T2 of the multiplication factor of the harmonic mixer (3) and the division factor T2 of the second frequency divider (6).

4. Control loop according to one of the preceding claims, **characterized**
- **in that** the first mixer (6) is connected via a third frequency divider (92) to the first input port (70) of the phase/frequency detector (7), of the phase detector or of the frequency detector,
- **in that** the ratio T1/T3 or T1/T2·T3 of the division factors T1, T3 of the first and of the third frequency divider (5, 6) and, respectively, of the first and of the second and third frequency dividers (5; 91, 92) is the same as the multiplication factor M of the harmonic mixer (3).

5. Control loop according to one of the preceding claims, **characterized in that** the output side of the phase/frequency detector (7), of the phase detector or of the frequency detector is followed by a control filter (8).

6. Control loop according to one of the preceding claims, **characterized in that** a delay element or a delay line is connected between the harmonic mixer (3) and the phase/frequency detector (7), the phase detector or the frequency detector, and/or between the pump oscillator (4) and the phase/frequency detector (7), the phase detector or the frequency detector.

7. Control loop according to one of the preceding claims, **characterized in that** the harmonic mixer (3) is replaced by a series circuit comprising a second mixer and a frequency multiplier connected between the second mixer and the pump oscillator.

## Revendications

1. Boucle de régulation pour stabiliser un oscillateur micro-ondes, **caractérisée par** les caractéristiques suivantes:
- un oscillateur de pompage (4) de fréquence fp est raccordé à sa sortie à la première porte d'entrée (61) d'un premier mélangeur (6) et à la première porte d'entrée (30) d'un mélangeur d'harmoniques (3),
- un signal de référence de fréquence f_{ref} est envoyé au premier mélangeur (6) par sa deuxième porte d'entrée (60),
- une partie découplée du signal de sortie de fréquence f_{osc} de l'oscillateur micro-ondes (1) est envoyée au mélangeur d'harmoniques (3) par sa deuxième porte d'entrée (31),
- un détecteur de phase/de fréquence (7) ou un détecteur de phase ou un détecteur de fréquence est raccordé par sa première porte d'entrée (70) à la porte de sortie (62) du premier mélangeur (6) et par sa deuxième porte d'entrée (71) à la porte de sortie (32) du mélangeur d'harmoniques (3) via un premier diviseur de fréquence (5) et par sa porte de sortie (72) à l'entrée de régulation (10) de l'oscillateur micro-ondes (1),
- le rapport T1/M du facteur de division T1 du premier diviseur de fréquence (5) au facteur de multiplication M du mélangeur d'harmoniques (3) est un nombre entier.

2. Boucle de régulation selon la revendication 1, **caractérisée en ce que**
- l'oscillateur de pompage (4) est raccordé au premier mélangeur (6) via un deuxième diviseur de fréquence (9),
- le rapport T1/T2 des facteurs de division T1, T2 du premier et du deuxième diviseurs de fréquence (5, 9) est égal au facteur de multiplication M du mélangeur d'harmoniques (3).

3. Boucle de régulation selon la revendication 2, **caractérisée en ce que** le premier diviseur de fréquence (5) se compose de deux diviseurs de fréquence partiels (51, 52) montés en série et **en ce que** le produit T11·T12 du facteur de division T11 du premier diviseur de fréquence partiel (51) avec le facteur de division T12 du deuxième diviseur de fréquence partiel (52) est égal au produit M·T2 du facteur de multiplication M du mélangeur d'harmoniques (3) et du facteur de division T2 du deuxième diviseur de fréquence (9).

4. Boucle de régulation selon l'une quelconque des revendications précédentes, **caractérisée en ce que**
- le premier mélangeur (6) est raccordé à la première porte d'entrée (70) du détecteur de phase/de fréquence (7) ou du détecteur de phase ou du détecteur de fréquence via un troisième diviseur de fréquence (92),
- le rapport T1/T3 respectivement T1/T2·T3 des facteurs de division T1, T3 du premier et du troisième diviseur de fréquence (5, 92) respectivement du premier et des deuxième et troisième diviseurs de fréquence (5; 91, 92) est égal au facteur de multiplication M du mélangeur d'harmoniques (3).

5. Boucle de régulation selon l'une quelconque des revendications précédentes, **caractérisée en ce qu'**un filtre de régulation (8) est placé à la sortie après le détecteur de phase/de fréquence (7) ou du détecteur de phase ou du détecteur de fréquence.

6. Boucle de régulation selon l'une quelconque des revendications précédentes, **caractérisée en ce qu'**un dispositif de retard ou une ligne à retard est placé ou placée entre le mélangeur d'harmoniques (3) et le détecteur de phase/de fréquence (7) ou le détecteur de phase ou le détecteur de fréquence et/ou entre l'oscillateur de pompage (4) et le détecteur de phase/de fréquence (7) ou le détecteur de phase ou le détecteur de fréquence.

7. Boucle de régulation selon l'une quelconque des revendications précédentes, **caractérisée en ce que** le mélangeur d'harmoniques (3) est remplacé par un circuit en série composé d'un deuxième mélangeur et d'un multiplicateur de fréquence monté entre le deuxième mélangeur et l'oscillateur de pompage.
